# EUROPEAN PATENT APPLICATION

(11) **EP 2 166 273 A2**
(43) Date of publication of application: **24.03.2010**
(21) Application number: 09011810.0
(22) Date of filing: 16.09.2009
(51) Int. Cl.: F21K 99/00, H01R 13/703, H01R 13/717, F21S 4/00, F21S 2/00

(54) **Light-emitting module, light-emitting device having the light-emitting module, and lighting apparatus having the light-emitting device**

(30) Priority: 22.09.2008 JP 2008242908
(71) Applicant: Toshiba Lighting & Technology Corporation, Yokosuka-shi Kanagawa 237-8510 (JP)
(72) Inventor: Watanabe, Hiroaki, Yokosuka-shi Kanagawa 237-8510 (JP)
(74) Representative: Kramer - Barske - Schmidtchen

(57) **Abstract**

A light-emitting module (1) has semiconductor light-emitting elements (11), a substrate (2), and a jointing connector (15). The semiconductor light-emitting elements (11) are mounted on the obverse of the substrate (2), and connected in series by conductive patterns (3, 4, 5, 6) formed on the substrate (2). The jointing connector (15) has a male terminal (17) and a female terminal (18), which are connected in series to the conductive patterns (3, 4, 5, 6). The jointing connector (15) has a connecting part connectable to other same-shaped jointing connector (15) arranged in point-symmetric for the jointing connector (15).

## Description

The present invention relates to a light-emitting module formed by connecting semiconductor light-emitting elements like light-emitting diodes in series, a light-emitting device formed by aligning the light-emitting modules, and a lighting apparatus having the light-emitting device.

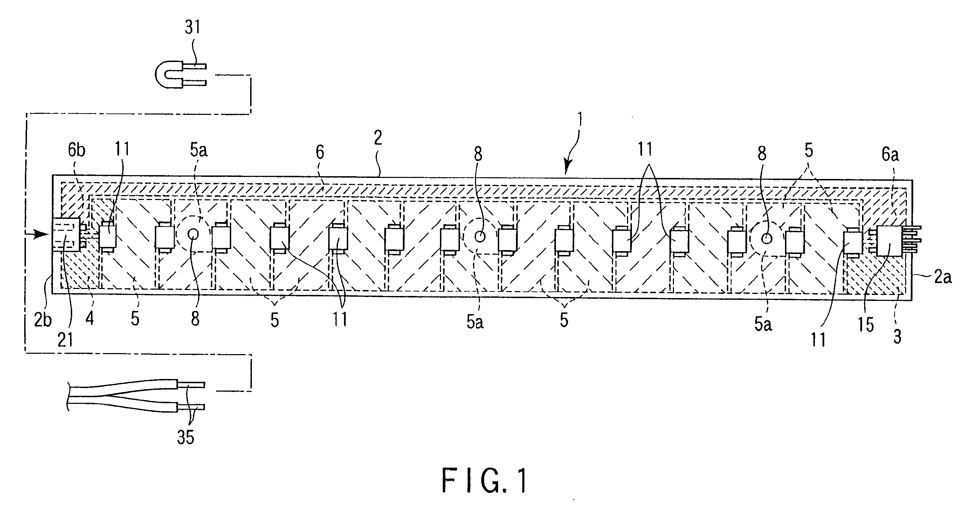

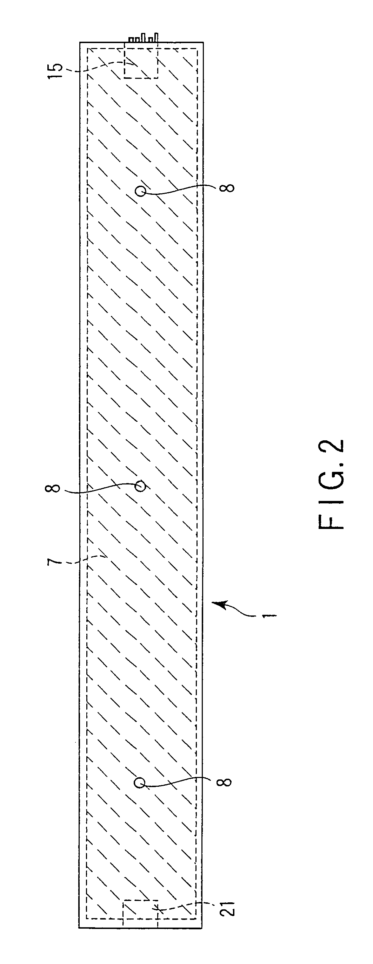

A light-emitting device, in which a line light source is formed by aligning light-emitting modules, has been known. Jpn. Pat. KOKAI Publication No. JP 2006-24861A discloses a light-emitting device, which has a light-emitting module provided with light-emitting diodes, in the paragraph 0020-0036, shows it in FIGS. 1 and 2. The light-emitting module has a removable connecting part at one end in the longitudinal direction of a substrate. The removable connecting part has a pair of positive and negative connecting pins projecting to the backside of the substrate. Wiring is formed on the substrate, and the connecting pins are connected to the wiring. Light-emitting diodes are arranged in line at regular intervals in the longitudinal direction of the substrate, and are connected in series.

The light-emitting device has a base part. The base part has connectors of the same number as the light-emitting modules at constant intervals. The connecting pins of the light-emitting modules are inserted into the connectors. Thereby, the light-emitting modules are aligned and secured to the base part. One end of the light-emitting module provided with a connecting pin is a fixed end positioned by a connector. The other end of the light-emitting module is a free end. Clearance is taken between the fixed end of a light-emitting module and the free end of another light-emitting module adjacent to the length of the base part, to permit thermal expansion to the free end in the longitudinal direction of a substrate. Adjacent connectors are connected in parallel through a cable or a terminal plate. In other words, the light-emitting modules are electrically connected in parallel.

The light-emitting modules disclosed in the Jpn. Pat. KOKAI Publication NO. JP 2006-24861A are arranged in line. However, each light-emitting module is independently provided, and connected in parallel. The Jpn. Pat. KOKAI Publication NO. JP 2006-24861A does not disclose a technique of lighting by serially connecting the light-emitting diodes of each light-emitting module arranged in line.

If a line-shaped light-emitting device is formed by mounting serially connected light-emitting diodes on a single substrate, the substrate becomes long. Thus, the substrate is largely warped by heat, either when the light-emitting diodes are mounted, or lit. This is unfavorable to a reliable product. A long substrate is difficult to control temperatures in each part, even if it can be set in a chip mounter for mounting a light-emitting diode. Further, a long substrate cannot be set in a chip mounter in some cases.

If the structure disclosed in the Jpn. Pat. KOKAI Publication No. JP 2006-24861A is adopted to reduce the substrate length, it is impossible to serially connect all light-emitting diodes of a substrate.

The present invention provides light-emitting diodes having the same structure, which are used as common parts in one light-emitting device. When the light-emitting modules are connected to form a light-emitting device, all semiconductor light-emitting elements mounted on each light-emitting module are connected in series. The invention also provides a light-emitting device provided with the light-emitting modules. The invention further provides a lighting apparatus provided with the light-emitting device as a light source.

A light-emitting module according to the invention has semiconductor light-emitting elements, a substrate, and a jointing connector. A substrate carries semiconductor light-emitting elements on its obverse, and has conductive patterns for a circuit to connect the semiconductor light-emitting elements in series. A jointing connector has male and female terminals connected in series to the conductive patterns. The jointing connector has a connecting part connectable to other same-shaped jointing connectors arranged in point-symmetric.

The light-emitting module has a distal connector having a pair of connecting terminals connected in series to the conductive patterns. The distal connector is connected to a power cable or a short-circuiting piece to connect the connecting terminals.

In this case, the jointing connector is arranged at one end in the longitudinal direction of the substrate, and the distal connector is arranged at the other end in the longitudinal direction of the substrate. In other words, the light-emitting module is an intermediate light-emitting module having jointing connectors arranged at both ends in the longitudinal direction of the substrate.

Male and female terminals of a jointing connector may be configured to be short-circuited when they are not connected to other same-shaped jointing connectors, and insulated when they are connected to other same-shaped jointing connectors. When they are connected to other same-shaped jointing connectors arranged in point-symmetric, they may have an open piece to cut off a short-circuit part between the male and female terminals of the counterpart jointing connector.

A light-emitting diode (LED) or an electroluminescent (EL) element are used as a semiconductor light-emitting element. In this case, the emission color of a light-emitting element is preferably white. The shape of a substrate is not particularly limited. The shape of a substrate of a light-emitting module is preferably rectangular, when it is used for a line-shaped light-emitting device.

In this specification, "electrically open a circuit" means that a circuit formed by serially connecting semiconductor light-emitting elements is cut off between male and female terminals, and the male and female terminals themselves are also electrically not connected, and that a circuit is cut off between a pair of connecting terminals, and the connecting terminals themselves are also electrically not connected. A semiconductor light-emitting element, jointing connector, and distal connector are preferably surface-mount parts.

A light-emitting module is connected in series to other light-emitting modules having the same structure, or indirectly connected to other light-emitting modules having the same structure through an intermediate light-emitting module. When two or more light-emitting modules are connected in line, a light-emitting module connected to one end of the line is closed as a circuit by inserting a short-circuiting piece into a pair of connecting terminals of a distal connector. Thereby, all semiconductor light-emitting elements of the connected light-emitting modules are connected in series.

In this case, jointing connectors of the other light-emitting modules adjacent to a jointing connector of one light-emitting module are arranged in point-symmetric, and connected to one another. A pair of connecting terminals of a distal connector positioned at the other end of the line of series-connected light-emitting modules is connected to positive and negative power cables, respectively. The series-connected semiconductor light-emitting elements are powered, and they are lit.

As described above, light-emitting modules can be arranged at both ends of a line when they are connected in line. In other words, a light-emitting module can be used as a common part of light-emitting modules used in a light-emitting device.

Further, male and female terminals of a jointing connector provided at least one in a light-emitting module may be configured to be short-circuited when they are not connected to other same-shaped jointing connectors, and insulated when they are connected to other same-shaped jointing connectors. When they are connected to other same-shaped jointing connectors arranged in point-symmetric, they preferably have an open piece to cut off a short-circuit part between the male and female terminals of the counterpart jointing connector.

In a light-emitting device according to the invention, when two or more light-emitting modules are connected in line, the light-emitting module described in above is arranged at both ends. In each light-emitting module, semiconductor light-emitting elements are mounted on a substrate on the obverse. The semiconductor light-emitting elements are connected in series by the conductive patterns formed on a substrate. In each light-emitting module, a jointing connector arranged adjacent to other light-emitting modules has the same structure as a jointing connector of the counterpart light-emitting module, and can be connected with each other. By connecting male and female terminals of jointing connectors arranged oppositely in point-symmetric, the semiconductor light-emitting elements of the adjacent light-emitting modules are connected in series. A short-circuiting piece is inserted into a pair of connecting terminals provided in a distal connector of a light-emitting module arranged at one end of a line. A power cable is inserted into a pair of connecting terminals provided in a distal connector of a light-emitting module arranged at the other end of a line.

In this specification, "a light-emitting module at both ends" indicates a light-emitting module arranged at both ends of a line, when two or more light-emitting module are arranged in line. Therefore, it indicates two light-emitting modules, when a light-emitting device comprise two light-emitting modules arranged in line in, and it indicates light-emitting modules arranged at both end of a line, when a line of light-emitting modules comprises more than two light-emitting modules. In this case, at least one intermediate light-emitting module is inserted between the light-emitting modules arranged at both ends.

"Other light-emitting module" indicates the other modules, when a line of light-emitting modules consists of two (a pair of) light-emitting modules, and one of them is called one module. It indicates an intermediate light-emitting module, when a line of light-emitting modules consists of more than two light-emitting modules including an intermediate light-emitting module. Further, "one of light-emitting module arranged at both ends" and "the other light-emitting module of light-emitting modules arranged at both ends" indicates one end or the other end of the light-emitting modules, when a line of light-emitting modules consists of more than two lighting modules, and does not indicate an intermediate light-emitting module.

In a light-emitting device formed by aligning light-emitting modules, light-emitting modules arranged at both ends of the line are the above-described light-emitting modules. Therefore, all semiconductor light-emitting elements mounted in each light-emitting module are connected in series. In a light-emitting device, at least two light-emitting modules arranged at both end have the same structure. Light-emitting modules arranged at both ends of a light-emitting device can be used as common parts.

A lighting apparatus according to the invention has the above-described light-emitting device as a light source. By using a light-emitting device in which all semiconductor light-emitting elements are connected in series, a lighting apparatus can be produced at low cost. Because, a light-emitting device consists of light-emitting modules, and the structure of each light-emitting module is common.

The invention can be more fully understood from the following detailed description when taken in conjunction with the accompanying drawings, in which:
FIG. 1 is a front view of a light-emitting module with a power line and a short-circuiting piece according to a first embodiment of the invention;
FIG. 2 is a rear view of the light-emitting module shown in FIG. 1;
FIG. 3 is a perspective view of a light-emitting device assembled by using two light-emitting modules shown in FIG. 1;
FIG. 4 is a front view of the light-emitting modules separated from the light-emitting device shown in FIG. 3;
FIG. 5 is a magnified front view of a jointing connector of the light-emitting module shown in FIG. 1;
FIG. 6 is a front view of connected jointing connectors of the light-emitting device shown in FIG. 3;
FIG. 7A is a rear view of a distal connector of the light-emitting module shown in FIG. 1;
FIG. 7B is a side view of a distal connector viewed from the direction of arrow F7B in FIG. 7A;
FIG. 8 is a perspective view of a lighting apparatus having the light-emitting device shown in FIG. 3 as a light source;
FIG. 9 is a plan view of a light-emitting device according to a second embodiment of the invention;
FIG. 10 is a sectional view of a lighting apparatus having the light-emitting device shown in FIG. 9 as a light source;
FIG. 11 is an exploded view of a light-emitting device according to a third embodiment of the invention;
FIG. 12 is a sectional view showing a jointing connector provided in each light-emitting module shown in FIG. 11, together with a jointing connector provided in other adjacent light-emitting module; and
FIG. 13 is a sectional view of the jointing connector shown in FIG. 12, connected to a jointing connector provided in other light-emitting module.

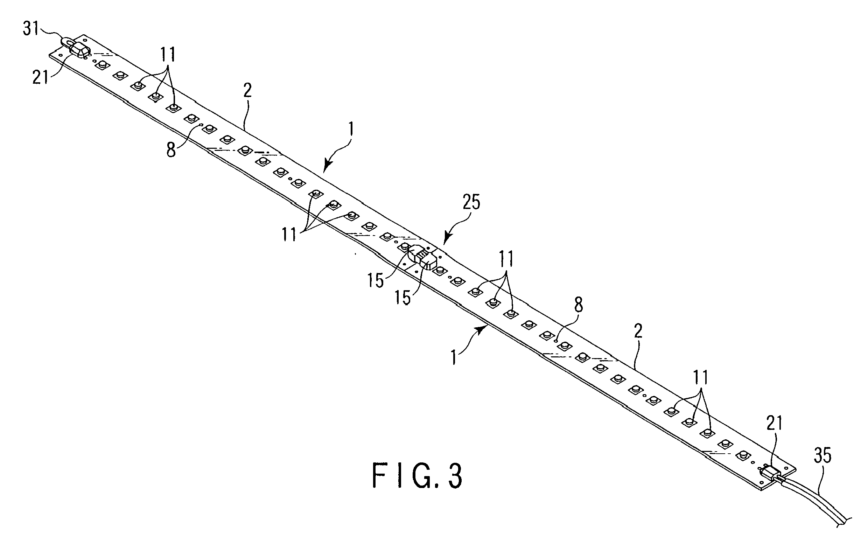

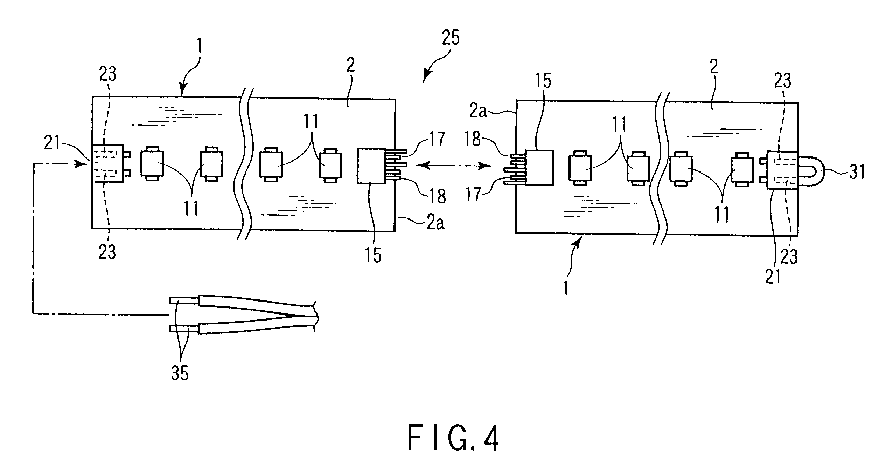

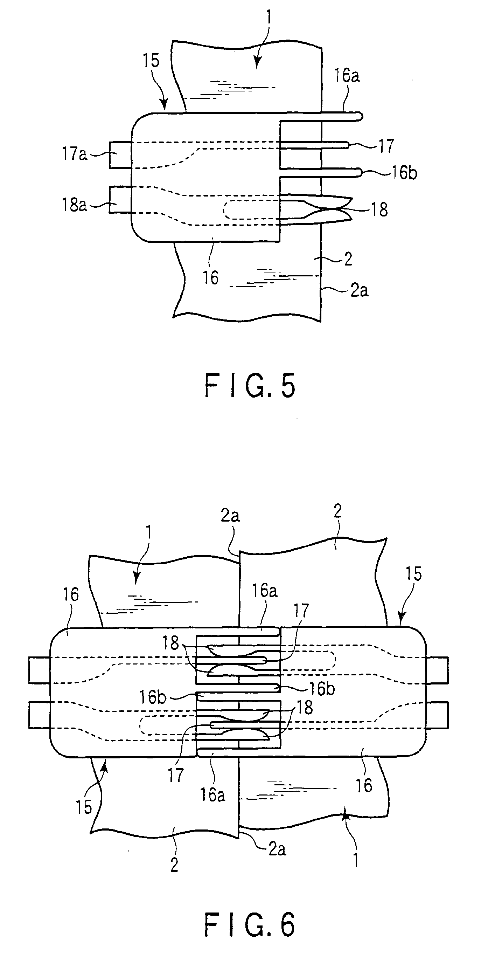

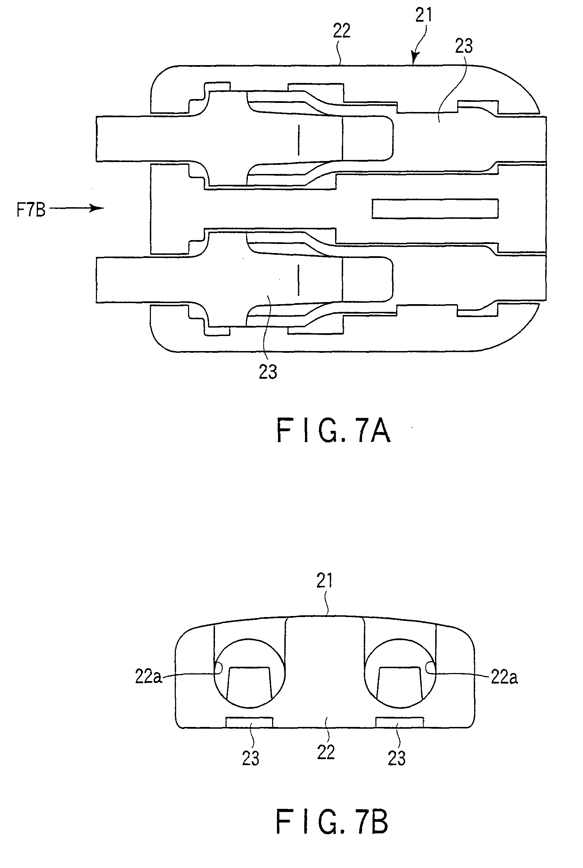

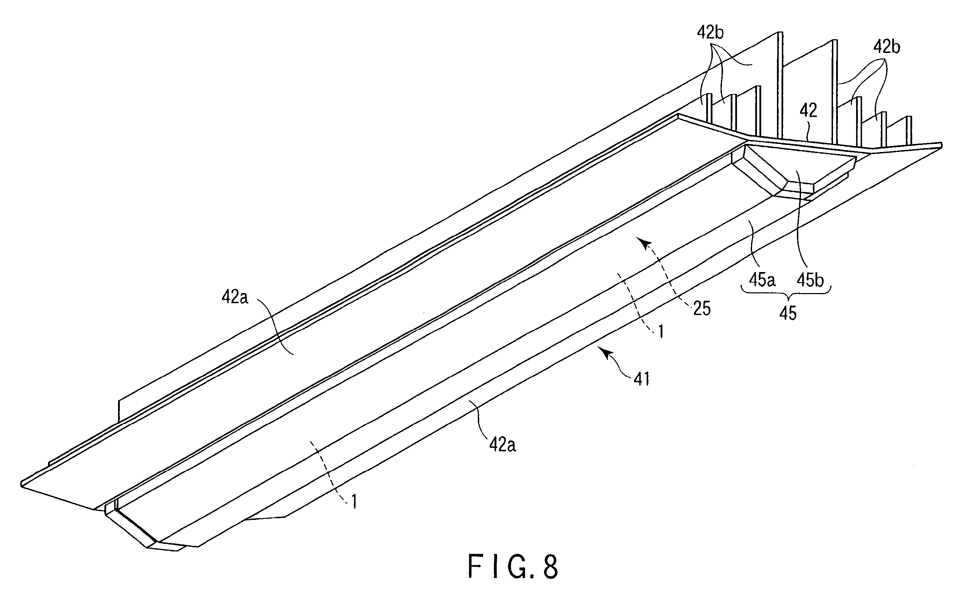

A light-emitting module 1, a light-emitting device 25, and a lighting apparatus 41 in a first embodiment of the invention will be described with reference to the accompanying drawings FIG. 1 to FIG. 8. FIGS. 1 and 2 show a light-emitting module 1. FIGS. 3 and 4 show a light-emitting device 25, which is formed by arranging same-structure light-emitting devices 1 in point-symmetric and connecting them. FIG. 8 shows a lighting apparatus 41 having the light-emitting device 25 as a light source. FIG. 5 shows a jointing connector 15 provided in the light-emitting module 1. FIG. 6 shows that two jointing connectors 15 are connected. FIG. 7A shows a distal connector 21. FIG. 7B shows a side view of the distal connector viewed from the inserting side.

The lighting apparatus 41 shown in FIG. 8 is to be installed on a ceiling, and is composed of a main body 42, a light-emitting device 25 fixed to the main body 42, and a light cover 45 which covers the light-emitting device 25 and is fixed to the main body 42. The main body 42 is made of aluminum alloy, and its appearance is rectangular when viewed from right below. Long side parts 42a of the main body 42 function as radiating parts, and are used as reflecting parts slightly bent upward. Radiating ribs 42b are projected as one part upward on the backside of the main body 42, opposite to the light-emitting side. The radiating ribs 42b are extended in the longitudinal direction of the main body 42. The light-emitting device 25 and light cover 45 are provided on the underside of the main body 42 between the side parts 42a. The light cover 45 is composed of a cover member 45a made of translucent synthetic resin, and end plates 45b to support the cover member 45a at both ends. The end plates 45b are fixed to the main body 42.

The light-emitting device 25 has a pair of light-emitting modules 1, and a short-circuiting piece 31, as shown in FIGS. 3 and 4. The light-emitting modules 1 have the same structure. These light-emitting modules 1 are arranged in point-symmetric and connected. Each light-emitting module 1 has a substrate 2, light-emitting diodes 11, a jointing connector 15, and a distal connector 21. The light-emitting diodes 11 are examples of semiconductor light-emitting elements, and emit white light, for example.

As shown in FIGS. 1 and 2, the substrate 2 is rectangular, for example. The substrate 2 is made mostly of insulating material such as glass epoxy resin. The substrate 2 has a circuit formed by serially connecting the light-emitting diodes 11 on the obverse that is a light-emitting side. The circuit is covered by an insulating film. The insulating film is preferably white to make the obverse of the substrate 2 reflective.

The circuit has a first conductive pattern 3, a second conductive pattern 4, two or more third conductive patterns 5, and a fourth conductive pattern 6. These conductive patterns are made of metal such as copper foil.

The first conductive pattern 3 and the second conductive pattern 4 are provided at both ends of the length of the substrate 2. The third conductive patterns 5 are provided between the first and second conductive patterns 3 and 4, in the longitudinal direction of the substrate 2. The fourth conductive pattern 6 is provided along the long side of the substrate 2, extending from beside of the first conductive pattern 3 to beside of the second conductive pattern 4.

One end portion 6a of the fourth conductive pattern 6 is adjacent to the first conductive pattern 3 along the in the width direction parallel to the short side of the substrate 2. The other end portion 6b of the fourth conductive pattern 6 is adjacent to the second conductive pattern 4 along the width direction parallel to the short side of the substrate 2. The first to third conductive patterns 3 to 5 occupy an area as wide as possible on the substrate 2 so as to function as a heat-spreader.

The first conductive pattern 3, and adjacent third pattern 5 and one end portion 6a of the fourth conductive pattern 6 are insulated by clearance formed between them. Similarly, the second conductive pattern 4, and adjacent third conductive pattern 5 and the other end portion 6b of the fourth conductive pattern 6 are insulated by clearance formed between them. The third conductive patterns 5 adjacent to one another are also insulated by clearance formed between them. The third conductive patterns 5 and fourth conductive pattern 6 are also insulated by clearance formed between them.

As shown in FIG. 2, the substrate 2 has a metal foil 7 on substantially the entire reverse surface. The metal foil 7 is made of copper foil, for example, and is covered by an insulating film. The metal foil 7 is used to equalize a temperature of the entire substrate 2 by receiving the heat diffused to the circuit and accelerate radiation to the main body 42. Thus the metal foil 7 is not electrically connected to the circuit.

As shown in FIGS. 1 and 2, the substrate 2 has fixing holes 8 penetrating through the thickness of the substrate. The substrate 2 is fixed to the main body 42 with the backside contacting the main body 42 by fixing screws inserted into the fixing holes 8. As shown in FIG. 1, the area around the fixing holes 8 forms pattern-missing spots 5a. The pattern-missing spots 5a are made one size larger than the diameter of a head of a fixing screw. The pattern-missing spots 5a do not divide the third conductive patterns 5, or do not affect conduction of the conductive patterns 5.

When the supply voltage is 100V, the light-emitting diodes 11 adopt power LEDS, each of which is lit by 3 - 5V. The light-emitting diodes 11 are arranged at constant intervals in the longitudinal direction of the substrate 2. The light-emitting diodes 11 are soldered to the surface of the substrate 2, and connected to the conductive patterns of the circuit, by surface mounting. The light-emitting diode 11 arranged at one end of the alignment is mounted over the first conductive pattern 3 and adjacent third conductive pattern 5. Similarly, the light-emitting diode 11 arranged at the other end of the alignment is mounted over the second conductive pattern 4 and adjacent third conductive pattern 5. The other light-emitting diodes 11 are mounted over adjacent third conductive patterns 5. The light-emitting diodes 11 are connected in series by being mounted as above.

As shown in FIG. 5, the jointing connector 15 consists of a case 16, and male terminal 17 and female terminal 18, which are provided in the case in an insulated state.

The case 16 of the jointing connector 15 is a synthetic resin molded part, and has first and second insulating projections 16a and 16b projecting as one unit from the distal end face of the case. The first insulating projection 16a is formed continuously from one side of the jointing case 16, and the second insulating projection 16b is provided in the inserting direction of the jointing connector 15 a little closer to the first insulating projection 16a with respect to a center line of the case 16. The first and second insulating projections 16a and 16b are projected by substantially the same length.

An inserting end of the male terminal 17 is shaped like a flat plate having the width in the thickness direction of the substrate 2, like the first and second insulating projections 16a and 16b, and is provided in parallel between the first and second insulating projections 16a and 16b. A soldered part 17a of the male terminal 17 to the substrate 2 is projected from the case 16 to the opposite side of the inserting end. A contact piece of the female terminal 18 consists of a pair of pinching members to hold the contact state by elastic force. The contact piece is provided on the opposite side of the male terminal 17 across the second insulating projection 16b. A soldered part 18a of the female terminal 18 to the substrate 2 is projected from the case 16 to the opposite side of the contact piece. The projecting lengths of the inserting end of the male terminal 17 and the contact piece of the female terminal 18 are substantially the same, and shorter than the first and second insulating projections 16a and 16b.

As shown in FIG. 1, the jointing connector 15 is located at one end of the length and at the center of the width of the substrate 2, and is mounted on the surface of the substrate 2. Thereby, the male terminal 17 of the jointing connector 15 is soldered to one end portion 6a of the fourth conductive pattern 6, and the female terminal 18 is soldered to the first conductive pattern 3. In other words, the jointing connector 15 is electrically connected in series to the circuit in which lighting-emitting diodes 11 are connected in series. The first insulating projection 16a, second insulating projection 16b, male terminal 17, and female terminal 18 of the jointing connector 15 are projected from one edge 2a of the substrate 2 in the longitudinal direction by substantially half of their lengths.

As shown in FIG. 7A, the distal connector 21 consists of a case 22, and a pair of connecting terminals 23 provided in the case in an insulated state with each other.

The case 22 of the distal connector 21 is a synthetic resin molded member, and has a pair of inserting ports 22a shown in FIG. 7B on one end face. Each of the inserting ports 22a is provided with a connecting terminal 23 continuously in the inserting direction. The connecting terminal 23 is constructed to hold a power cable inserted from the inserting port 22a to prevent the power cable from carelessly disconnecting.

As shown in FIG. 1, the distal connector 21 is located at the other end of the length and at the center of the width of the substrate 2, and is mounted on the obverse of the substrate 2. The one connecting terminal 23 is soldered to the other end portion 6b of the fourth conductive pattern 6, and the other connecting terminal 23 is soldered to the second conductive pattern 4. Therefore, the distal connector 21 is electrically connected in series to the circuit, in which the light-emitting diodes 11 are connected in series. In this embodiment, the distal connector case 22 is mounted by aligning one end face of the case 22 of the distal connector 21 whose inserting port 22a is opened, with the other end edge 2b of the length of the substrate 2. The mounting is not limited to this. The distal connector 21 may be at a position away from the other edge 2b, that is, at a backward position, or at a slightly projected position.

As the jointing connector 15 and distal connector 21 are connected in series to the circuit, it is necessary to close the circuit by connecting something to each connector. Therefore, the circuit is held open while nothing is connected to the connector.

As shown in FIG. 1, the distal connector 21 is connected to the short-circuiting piece 31 or power cable 35. The short-circuiting piece 31 and power cable 35 are insulating sheath cables. When the short-circuiting piece 31 is inserted into the distal connector 21, a pair of connecting terminals 23 becomes conductive by the short-circuiting piece 31. In other words, the circuit is closed in the distal connector 21 by being inserted the short-circuiting piece 31. The circuit is powered, when the power cable 35 connected to a power supply unit is inserted into the distal connector 21.

Next, an assembling process of the light-emitting device 25 will be explained by followings. First, two same-structure light-emitting modules 1 are prepared, and arranged in point-symmetric, so that the distal connectors 21 face to each other, as shown in FIG. 4. Then, the modules are moved so that one edge 2a of the modules contact, and the jointing connectors 15 arranged in point asymmetric are connected.

At this time, as the light-emitting modules 1 are moved closer to each other, the inserting end of the male terminal 17 of one jointing connector 15 pushes and opens the contact piece of the female terminal 18 of the other jointing connector 15, and is inserted into the female terminal 18, thereby the male terminal 17 and female terminal 18 are mechanically and electrically connected. The connected part is surrounded by the first and second insulating projections 16a and 16b of one jointing connector 15, and the distal end faces of both jointing connectors 15. At the same time, the inserting end of the male terminal 17 of the other jointing connector 15 pushes and opens the contact piece of the female terminal 18 of one jointing connector 15, and is inserted into the female terminal 18, thereby the male terminal 17 and female terminal 18 are mechanically and electrically connected. The connected part is also surrounded by the first and second insulating projections 16a and 16b of the other jointing connector 15, and the distal end faces of both jointing connectors 15. FIG. 6 shows the state in which the jointing connectors 15 are connected.

As a result, two light-emitting modules 1 arranged to face each other in point-symmetric are connected in line as shown in FIG. 3, and the circuits of the light-emitting modules 1 are electrically connected in series.

Next, the short-circuiting piece 31 is inserted into the pair of connecting terminals 23 of the distal connector 21 of one of the light-emitting modules 1 connected by the jointing connector 15. The circuit, in which the light-emitting diodes 11 are connected in series, is electrically closed in one distal connector 21. Therefore, the circuit formed over two light-emitting modules 1 forms a series circuit. The short-circuiting piece 31 may be previously assembled to one light-emitting module 1.

Finally, the power cable 35 comprising a pair of positive and negative polarities is inserted into a pair of connecting terminals 23 of the distal connector 21 of the other light-emitting module 1 opposite to the one into which the short-circuiting piece 31 is inserted. Thereby, each light-emitting diode 11 becomes to be able to supply power to the series-circuit to which each light-emitting diode 11 is connected, and the light-emitting device 25 is completely assembled.

The light-emitting device 25 can be powered by connecting the input end portion of the power cable 35 to a separately prepared power supply unit. The power cable 35 can be previously connected to the other light-emitting module 1, or the light-emitting module 1 not connected to the short-circuiting piece 31. This is preferable from the viewpoint of preventing the power cable 35 from being obstructive when the light-emitting device 25 is assembled.

In the light-emitting device 25, the circuits of two light-emitting modules 1 are connected in series by the jointing connector 15. In the light-emitting device 25, a circuit is electrically opened at one end of the elongate light-emitting device 25 for connecting the power cable 35, and is electrically closed at the other end of the light-emitting device 25. In the light-emitting modules 1 connected in line, the light-emitting modules 1 arranged at both ends of the line have the same structure.

In other words, the light-emitting module arranged at one end of a line, that is, one light-emitting module 1 in this embodiment, is not one in which a circuit is closed by a pattern, but one which has the distal connector 21 connectable either to the short-circuiting piece 31 to close a circuit, or the power cable 35 for supplying power to a circuit. Similarly, the light-emitting module arranged at the other end of a line, that is, the other light-emitting module 1 in this embodiment, is one which has the distal connector 21 connectable either to the short-circuiting piece 31 to electrically close a circuit, or the power cable 35 for supplying power to a circuit. In other words, the structures of the distal connectors 21 are the same. The jointing connectors 15 for connecting the light-emitting modules 1 have the same structure, and can be arranged in point-symmetric, and connected each other.

In the light-emitting device 25, all light-emitting diodes 11 mounted in each of the connected light-emitting module 1 are connected in series, and constructed so that the power cable 35 is connected to one end. Even in this case, the light-emitting modules 1 arranged at both ends can have the same structure, by providing the jointing connector 15 and distal connector 21 having the above structure.

Since light-emitting modules 1 at both ends of the light-emitting device 25 are used same-structure, the varieties of parts can be decreased, and inventory control becomes easy. This can decrease the total cost of the light-emitting device 25. Further, in this embodiment, the light-emitting device 25 has two light-emitting modules 1. In other words, the light-emitting modules 1 are common and one-sort parts. This makes it easy to assemble the unit without assembling wrong parts.

In the light-emitting device 25, light-emitting modules 1 are connected in line, and each length of the light-emitting modules 1 can be reduced. This is preferable in the following points comparing with a light-emitting device using one long substrate. When the light-emitting diodes 11 are mounted on the substrate 2, or when the light-emitting diodes 11 are lit, warping of the substrate 2 caused by heat can be minimized. The light-emitting device 25 is increased in dimensional stability, and becomes a reliable product. The substrate 2 is short and easy to handle, and can easily set in a chip mounter for mounting the light-emitting diodes 11 without causing difficulty in temperature control in the chip mounter. Therefore, the lighting diodes 11, jointing connector 15, and distal connector 21 can easily be mounted on the substrate 2.

The lighting diodes 11, jointing connector 15, and distal connector 21 are mounted on the obverse of the substrate 2. Therefore, a large heat-transmitting area is ensured on the reverse side of the substrate 2. This increases the effect of diffusing the heat of the light-emitting device 25 from the reverse side of the substrate 2 to the main body 42.

In a light-emitting device of the type in which the power cable 35 is inserted from the reverse side of the substrate 2 and soldered to conductive patterns on the obverse side, a heat-transmitting area must be decreased to ensure insulation between the power cable 35 and the metallic heat-transmitting surface formed on the reverse side of the substrate 2. Further, it is necessary to create clearance in the main body 42 for routing the power cable led out to the backside of the substrate 2. Thus, it is also necessary to decrease a contact area between the main body 42 and the backside of the substrate 2. Such compromises are unnecessary in the light-emitting device 25 of this embodiment. In other words, the jointing connector 15 and distal connector 21 are surface-mount parts, and no connector and power cable are provided on the reverse side of the substrate 2. Therefore, it is possible to efficiently transmit the heat from the backside of the light-emitting device 25 to the main body 42.

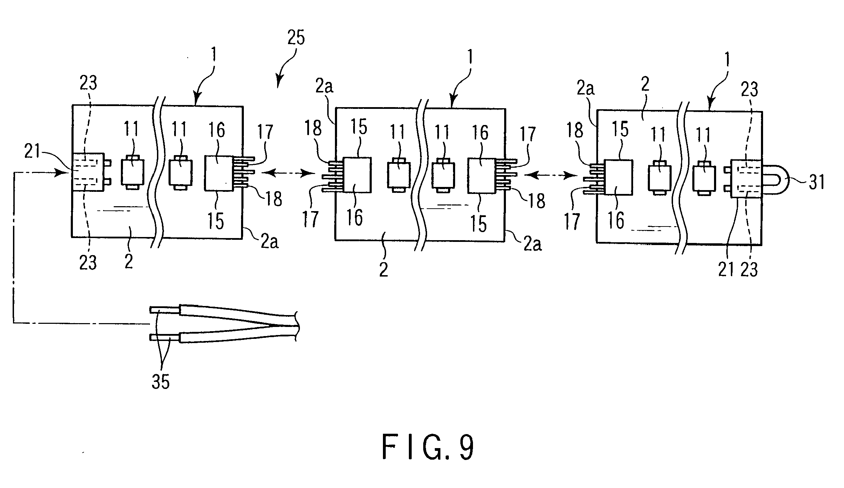

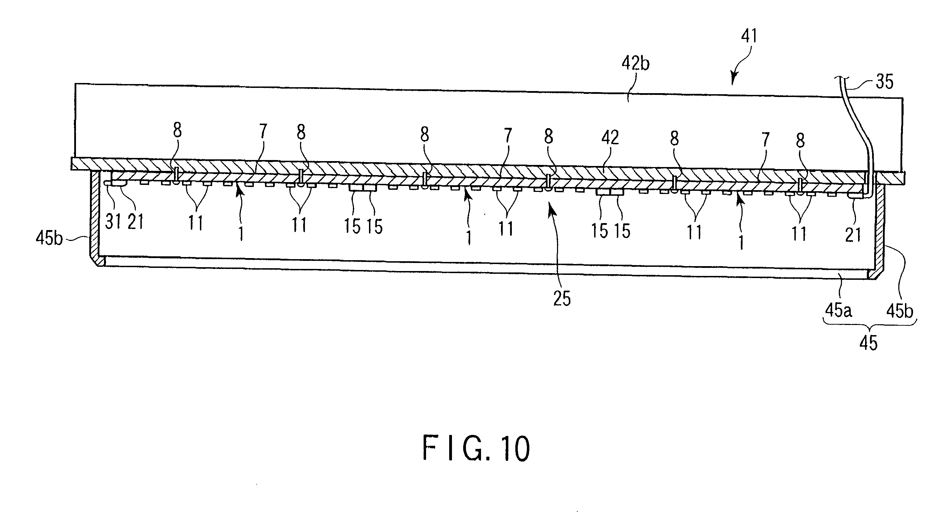

A light-emitting device 25 and a lighting apparatus 41 according to a second embodiment of the invention will be described with reference to FIG. 9 and FIG. 10. The light-emitting device 25 of this embodiment comprises at least three light-emitting modules 1 connected in line. The light-emitting modules 1 arranged at both ends are the same as the light-emitting module 1 explained in the first embodiment, and an explanation thereof is omitted. The components having the same functions as those of the light-emitting module 1 in the first embodiment are given the same reference numbers in the drawings, and an explanation thereof is omitted.

The light-emitting device 25 shown in FIG. 9 consists of three light-emitting modules 1 connected in the longitudinal direction. The light-emitting modules 1 arranged at both ends have a distal connector 21 at a position to be an end portion of the light-emitting device 25 connected as a light-emitting device 25, and has a jointing connector 15 at the end portion opposing the intermediate light-emitting module 1. In the intermediate light-emitting module 1, light-emitting diodes 11 and a pair of jointing connectors 15 are mounted on the substrate 2. The light-emitting diodes 11 and jointing connectors 15 are connected in series by conductive patterns 3, 4, 5 and 6 formed on the substrate 2.

The light-emitting module 1 for mid position has a jointing connector 15 in both end portions of the substrate 2. As shown in FIG. 9, these jointing connectors 15 are arranged in point-symmetric in the end portions of the intermediate light-emitting module
1. The jointing connectors 15 have the same shape as the jointing connectors provided in the adjacent light-emitting modules 1, and can connect them. Therefore, the intermediate light-emitting module 1 is positioned between the light-emitting modules 1 arranged in point-symmetric in both end portions of the light-emitting device 25, and connects them. The intermediate light-emitting module 1 itself is two-rotation symmetric. Therefore, the intermediate light-emitting module 1 can be connected to adjacent light-emitting modules 1 in either direction. The number of light-emitting modules comprising the light-emitting device 25 is not limited to three, and may be four or more. In this case, the number of intermediate light-emitting modules 1 is increased to two or more.

FIG. 10 shows a lighting apparatus 41 having a light-emitting device 25, in which three light-emitting modules 1 including one intermediate light-emitting module are connected, as a light source. The light-emitting modules 1 of the light-emitting device 25 are connected to one another by jointing connectors 15. A short-circuiting piece 31 is fit to a distal connector 21 located in one end portion of the light-emitting device 25. Thereby, all light-emitting diodes 11 of the light-emitting device 25 are connected in series. A distal connector 21 positioned in the other end portion of the light-emitting device 25 is connected to a power cable 35 wired through a main body 42 of the lighting apparatus 41.

The light-emitting diodes 11, jointing connector 15, and distal connector 21 are all mounted on the obverse, that is, a light-emitting side of the substrate 2. The reverse side of the substrate 2 is smooth, and a metal foil 7 such as a copper foil is formed as a heat-transmitting surface on substantially the whole backside surface. The metal foil 7 is insulated from a circuit of the light-emitting module 1, and the outside surface is covered with an insulating film. As shown in FIG. 10, the backside of the light-emitting device 25 is tightly fixed to the main body 42 with fixing screws inserted into fixing holes 8.

The light-emitting device 25 configured as above can be easily changed in the total length in units of the length of the intermediate light-emitting module 1, by increasing the number of the intermediate light-emitting modules 1. The intermediate light-emitting module 1 has the same-shape jointing terminal 15 at both ends, and the inserting direction of the intermediate light-emitting module 1 is not limited. This improves the workability of assembling. The light-emitting modules 1 arranged at both ends of the light-emitting device 25 have the same structure provided with a jointing connector 15 at one end, and a distal connector 21 at the other end. Therefore, only one sorts of light-emitting modules may be used for each intermediate light-emitting module 1 and end light-emitting modules 1. As parts are standardized, the production line and quality control costs can be reduced.

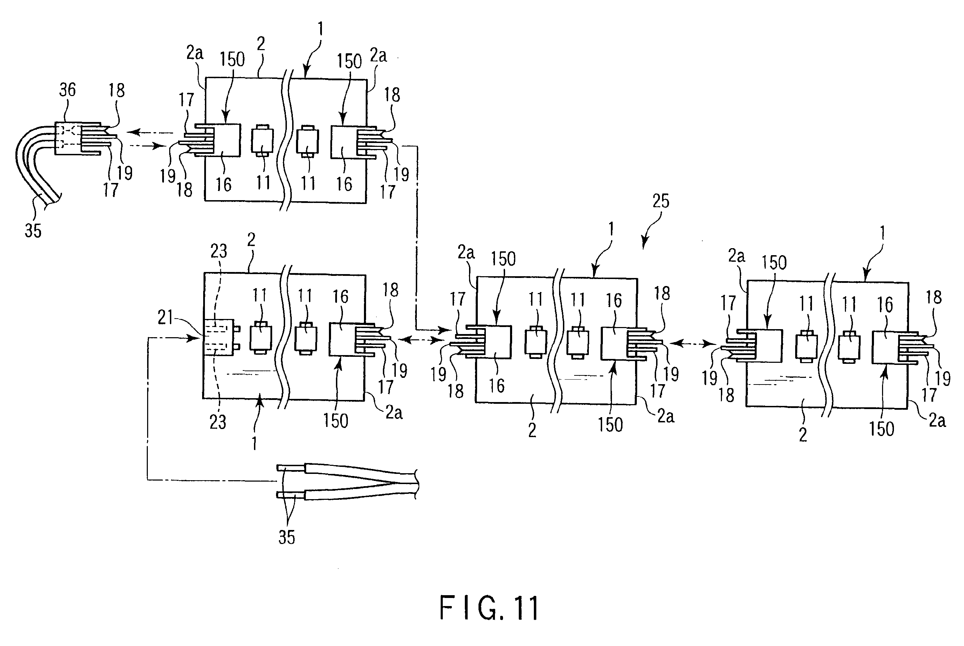

A light-emitting device 25 according to a third embodiment of the invention will be described with reference to FIG. 11 to FIG. 13. In the light-emitting device 25 of this embodiment, the structure of a jointing connector 150 for physically and electrically connecting light-emitting modules 1 is different from the jointing connector 15 in the other embodiments. The other components are the same as the light-emitting device 25 of the first and second embodiments. A lighting apparatus having the light-emitting device 25 as a light source has the same structure as the lighting apparatus 41 of the first and second embodiments. Therefore, an explanation thereof is omitted. FIGS. 8 and 10, and explanation thereof will be referred to.

The light-emitting device 25 shown in FIG. 11 has one light-emitting module 1, which has a distal connector 21 at one end, and a jointing connector 150 at the other end, for connecting a power cable 35. The other light-emitting modules 1 forming the light-emitting device 25 have the same-shaped jointing connector 150 at both ends of the longitudinal direction. The jointing connector 150 has a male terminal 17 and a female terminal 18 connected in series to the circuit of the light-emitting module 1.

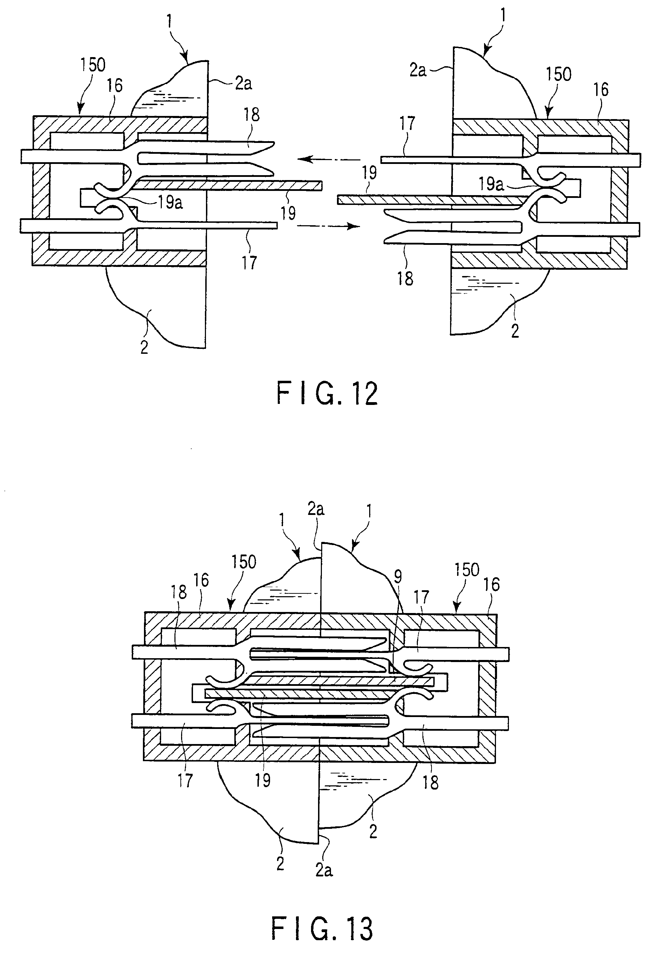

As shown in FIGS. 12 and 13, the jointing connector 150 has a connecting part connectable with other same-shaped jointing connectors 150 arranged in point-symmetric. A male terminal 17 and a female terminal 18 of this jointing connector 150 are short-circuited by a short-circuiting part 19a when they are not connected to the other same-shaped jointing connector 150 as shown in FIG. 12, and the short-circuiting part 19a is cut off when they are connected to the other same-shaped jointing connector 150 as shown in FIG. 13. The male terminal 17 and female terminal 18 has a flexible tongue piece respectively extending oppositely from the male and female terminals 17 and 18. The tongue pieces are contact with each other at the short-circuiting part 19a.

As shown in FIG. 12, the jointing connector 150 has an open piece 19 to cut off the short-circuiting part 19a of the counterpart jointing connector 150, when it is connected to other same-shaped jointing connector arranged in point-symmetric. The open piece 19 is longer than the male and female terminals 17 and 18 in the inserting direction of the jointing connector 150. The open piece 19 is made of insulating material. In this embodiment, the open piece 19 is formed in one piece with the case 16. The open piece 19 is inserted into the short-circuiting part 19a of the counterpart jointing connector 150 as shown in FIG. 13, when the jointing connector 150 is connected. The male and female terminals 17 and 18 are short-circuited by disconnecting the connected jointing connectors 150.

The male terminal 17 and female terminal 18 of the jointing connector 150 are short-circuited, when the jointing connector 150 is not connected. When the jointing connector 150 is connected to other jointing connector 150, the open piece 19 separates the short-circuiting part 19a of the male and female terminals 17 and 18 of the counterpart jointing connector 150, and the male terminal 17 is connected to the female terminal 18 of the counterpart connector, and the female terminal 18 is connected to the male terminal 17 of the counterpart connector. Further, the male and female terminals 17 and 18 of the jointing connector 150 are connected in series to the circuit of the light-emitting module 1, and short-circuited when the jointing connector 150 is not connected to other jointing connector 150. Therefore, the circuit of the light-emitting module 1 is electrically closed.

Therefore, in FIG. 11, when the light-emitting device 25 is assembled, the power cable 35 is simply connected to the light-emitting module 1 having the distal connector 21, and then the necessary number of light-emitting modules 1 having the jointing connector 150 at both ends is jointed. Simply by connecting the light-emitting modules 1 having the jointing connector 150 at both ends, the circuit is connected in series to the adjacent light-emitting module 1. Since the male terminal 17 and female terminal 18 are short-circuited when the jointing connector 150 is not connected with the other connector, it is not necessary to provide the short-circuiting piece 31.

Further, the light-emitting device 25 may comprises one sort of light-emitting modules 1 having a jointing connector 150 at both ends by using the light-emitting module 1 illustrated in parallel with the light-emitting module 1 having the distal connector 21 shown in FIG. 11. In this case, the power cable 35 is provided with a socket 36 having a connecting part of the same shape as the connecting part of the jointing connector 150, so as to connect the jointing connector 150 arranged in an end portion of the light-emitting device 25. The socket 36 has a male terminal 17, a female terminal 18, and an open piece 19. When the socket 36 connects to the jointing connector 150, the male terminal 17 of the socket 36 is connected to the female terminal 18 of the jointing connector 150, and the female terminal 18 of the socket 36 is connected to the male terminal 17 of the jointing connector 150. The open piece 19 of the socket 36 separates the short-circuiting part 19a between the male terminal 17 and female terminal 18 of the jointing connector 150. The socket 36 does not have a short-circuit part, and the male terminal 17 and female terminal 18 are insulated, even if the jointing connector is not connected.

As described above, in the light-emitting device 25 in which the power cable 35 is provided with the socket 36 connectable to the jointing connector 150, the structures of the light-emitting modules 1 forming the light-emitting device 25 can be limited to one sort. In the jointing connector 150, the male terminal 17 and female terminal 18 are short-circuited when the jointing connector 150 is not connected, and the male terminal 17 and female terminal 18 insulated when the jointing connector 150 is connected. Therefore, the circuit of the jointing connector 150, which is arranged at an end of the light-emitting device 25 and connected to nothing, is closed as it is. In the connected light-emitting modules 1, the circuits of adjacent light-emitting modules 1 are connected in series simply by connecting the jointing connector 150.

Hence, all light-emitting diodes 11 are connected in series in the light-emitting device 25, by just connecting the necessary number of light-emitting modules 1 and connecting either side of the power cable 35 provided with the socket 36 when the light-emitting device 25 is assembled. This simplifies assembling of the light-emitting device 25. The only one sort of the light-emitting module 1 is applied to assembling the light-emitting device 25. The only on sort of the connector, which is the jointing connector 150, is applied to the light-emitting module 1. The length of the light-emitting device 25 can be changed only by changing the number of the light-emitting modules 1 to be connected.

The light-emitting device 25 according to the invention is not limited to the first to third embodiments. For example, in the first embodiment, the light-emitting device 25 is formed by connecting two light-emitting modules 1. In the second embodiment, the light-emitting device 25 is formed by inserting an intermediate light-emitting module between two light-emitting modules of the first embodiment, and connecting three light-emitting modules in line. In this case, a longer light-emitting device can be formed by increasing the number of the intermediate light-emitting modules 1. In either case, the light-emitting modules 1 arranged at both ends of the line can be used as common parts. At least one intermediate light-emitting module positioned between a pair of light-emitting modules 1 arranged at both ends of the light-emitting device 25 is provided with a jointing connector 15 in both end portions of a substrate on which the light-emitting diode 11 is mounted.

Further, in the third embodiment, the light-emitting device 25 is formed by connecting two or more light-emitting modules 1 provided with the jointing connector 150 having the mechanism of closing the circuit when not-connected and opening the circuit when connected, at both ends. The power cable 35 may be connected in series to the circuit of the light-emitting device 25 through the distal connector 21 of the first and second embodiments, or through the socket 36 connectable to the jointing connector 150.

The light-emitting module 1 is formed by aligning the light-emitting diodes 11 on a rectangular substrate. However, the diodes may be arranged in any form on the substrate 2 as long as they are connected in series. Two or more modules may not be aligned in the longitudinal direction, or may be arranged by butting the long sides of a rectangle. In this case, the jointing connectors 15 and 150 are arranged on the long sides so as to project from the edge. Therefore the shape of the substrate 2 is not limited to a rectangle, and may be circular, square, triangular, or trapezoidal, as long as semiconductor light-emitting elements can be connected in series on substrates of light-emitting modules which are jointed.

In either cases, the jointing connectors 15 and 150 are provided in adjacent light-emitting modules, so that they are connected to other jointing connectors 15 and 150 arranged in point-symmetric. Thereby, at least the light-emitting modules 1 arranged at both ends of the light-emitting device 25 can have the same shape. Further, the intermediate light-emitting module 1 inserted between the light-emitting modules 1 arranged at both ends can have the same shape.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A light-emitting module (1) **characterized by** comprising:
semiconductor light-emitting elements (11);
a substrate (2) carrying the semiconductor light-emitting elements (11) on the obverse, and conductive patterns (3, 4, 5, 6) for a circuit to connect the mounted semiconductor light-emitting elements (11) in series; and
a jointing connector (15) having male and female terminals (17, 18) connected in series to the conductive patterns (3, 4, 5, 6), and a connecting part connected to other same-shaped jointing connector (15) arranged in point-symmetric.

2. The light-emitting module (1) according to claim 1, **characterized by** further comprising
a distal connector (21), which is provided with a pair of connecting terminals (23) connected in series to the conductive patterns (3, 4, 5, 6), and is connected to a power cable (35) or a short-circuit piece (31) to connect the connecting terminals (23).

3. The light-emitting module(1) according to claim 2, **characterized in that**
the jointing connector (15) is arranged at one end of the length of the substrate (2); and
the distal connector (21) is arranged at the other end of the length of the substrate (2).

4. The light-emitting module (1) according to claim 1, **characterized in that**
the jointing connector (15) is arranged at both ends of the length of the substrate (2).

5. The light-emitting module (1) according to claim 1, **characterized in that**
the male and female terminals (17, 18) of the jointing connector (15) are short-circuited when not connected to other same-shaped jointing connector (15), and are insulated when connected to other same-shaped jointing connector (15).

6. The light-emitting module (1) according to claim 5, **characterized in that**
the jointing connector (15) has an open piece (19), which separates a short-circuit part (19a) between male and female terminals (17, 18) of a counterpart jointing connector (15) when connected to other same-shaped jointing connector (15) arranged in point-symmetric.

7. The light-emitting module (1) according to claim 6, **characterized by** further comprising:
a distal connector (21), which is provided with a pair of connecting terminals (23) connected in series to the conductive patterns (3, 4, 5, 6), and is connected to a power cable (35) or a short-circuit piece (31) to connect the connecting terminals (23),
wherein
the jointing connector (15) is arranged at one end of the length of the substrate (2); and
the distal connector (21) is arranged at the other end of the length of the substrate (2).

8. The light-emitting module (1) according to claim 6, **characterized in that** the jointing connector (15) is arranged at both ends of the length of the substrate (2).

9. A light-emitting device (25) **characterized by** comprising:
a pair of light-emitting modules (1) comprising: (a) semiconductor light-emitting elements (11); (b) a jointing connector (15) having male and female terminals (17, 18); and (c) a distal connector (21) having a pair of connecting terminals (23) are mounted on a substrate (2); wherein the semiconductor light-emitting elements (11), jointing connector (15), and distal connector (21) are connected in series by conductive patterns (3, 4, 5, 6) formed on the substrate (2); and the light-emitting modules (1) are made to have the same structure, arranged in point-symmetric, and connected by the jointing connector (15); and a short-circuit piece (31) which connects the pairs of connecting terminals (23) of the distal connector (21) of one of the light-emitting modules (1), wherein the pair of connecting terminals (23) of the distal connector (21) of the other light-emitting module (1) is connected to a power cable (35).

10. The light-emitting device (25) according to claim 9, **characterized by** further comprising:
an intermediate light-emitting module (1) comprising: (a) semiconductor light-emitting elements (11); (b) a jointing connector (15) which has the same shape as the jointing connector (15) provided in the light-emitting module (1) which is arranged on one end of a line of the light-emitting modules (1), the jointing connector (15) is arranged as a pair corresponding to the jointing connector (15) of the pair of light-emitting modules (1); wherein the semiconductor light-emitting elements (11) and the pair of jointing connectors (15) are mounted on a substrate (2) and are connected in series by conductive patterns (3, 4, 5, 6) formed on the substrate (2); and the intermediate light-emitting module (1) is connected between the jointing connectors (15) of the pair of light-emitting modules (1) arranged in point-symmetric.

11. A lighting apparatus (41) having a light-emitting device (25) as a light source, the light-emitting device (25) **characterized by** comprising:
a pair of light-emitting modules (1), comprising: (a) semiconductor light-emitting elements (11), (b) a jointing connector (15) having male and female terminals (17, 18), and (c) a distal connector (21) having a pair of connecting terminals (23) are mounted on a substrate (2); wherein the semiconductor light-emitting elements (11), jointing connector (15) and distal connector (21) are connected in series by conductive patterns (3, 4, 5, 6) formed on the substrate (2); and the light-emitting modules (1) are made to have the same structure, arranged in point-symmetric, and connected by the jointing connector (15); and
a short-circuit piece (31) which connects the pairs of connecting terminals (23) of the distal connector (21) of one of the light-emitting modules (1),
wherein the pair of connecting terminals (23) of the distal connector (21) of the other light-emitting module (1) is connected to a power cable (35).
an intermediate light-emitting module (1) comprising: (a) semiconductor light-emitting elements (11); (b) a jointing connector (15) which has the same shape as the jointing connector (15) provided in the light-emitting module (1) which is arranged on one end of a line of the light-emitting modules (1), the jointing connector (15) is arranged as a pair corresponding to the jointing connector (15) of the pair of light-emitting modules (1); wherein the semiconductor light-emitting elements (11) and the pair of jointing connectors (15) are mounted on a substrate (2) and are connected in series by conductive patterns (3, 4, 5, 6) formed on the substrate (2); and the intermediate light-emitting module (1) is connected between the jointing connectors (15) of the pair of light-emitting modules (1) arranged in point-symmetric.
12. The lighting apparatus (41) according to claim 11, **characterized by** further comprising:
